# EUROPÄISCHE PATENTSCHRIFT

(11) **EP 3 378 082 B1**
(45) Veröffentlichungstag und Bekanntmachung des Hinweises auf die Patenterteilung: **22.04.2020**
(21) Anmeldenummer: 16805028.4
(22) Anmeldetag: 21.11.2016
(51) Int. Cl.: H01H 13/70, G06F 3/044, H03K 17/96

(54) **FERNBEDIENUNG MIT ALS KAPAZITIVER SENSOR AUSGEBILDETE STABILISIERUNGSFOLIE**
REMOTE CONTROL WITH STABILIZATION FILM DESIGNED AS CAPACITIVE SENSOR
COMMANDE À DISTANCE COMPORTANT UN FILM DE STABILISATION SOUS FORME DE CAPTEUR CAPACITIF

(30) Priorität: 20.11.2015 DE 102015120174
(43) Veröffentlichungstag der Anmeldung: 26.09.2018
(73) Patentinhaber: fm marketing gmbh, 5202 Neumarkt am Wallersee (AT)
(72) Erfinder: MAIER, Ferdinand, 5202 Neumarkt am Wallersee (AT)
(74) Vertreter: von Bülow & Tamada
(86) Internationale Anmeldenummer: PCT/EP2016/078357
(87) Internationale Veröffentlichungsnummer: WO 2017/085328

(56) Entgegenhaltungen:
- EP-A2- 1 197 835
- US-A1- 2005 030 048
- US-A1- 2011 205 161

## Beschreibung

Die vorliegende Erfindung betrifft eine Fernbedienung.

Eine Fernbedienung ist beispielsweise aus der DE 10 2013 018 156 B3 bekannt. Sie umfasst eine erste Informationseinleseeinrichtung und eine zweite Informationseinleseeinrichtung, die jeweils eingerichtet sind, eine Information basierend auf einem Druck eines Benutzers in einer Druckrichtung einzulesen. Die Fernbedienung umfasst ferner ein der ersten Informationseinleseeinrichtung zugeordnetes erstes Druckaufnahmeelement und ein der zweiten Informationseinleseeinrichtung zugeordnetes zweites Druckaufnahmeelement, die jeweils eine Druckaufnahmeseite zum Aufnehmen des Druckes vom Benutzer und eine Druckabgabeseite zum Abgeben des aufgenommenen Druckes an die jeweilige Informationseinleseeinrichtung besitzen. Die beiden Druckaufnahmeelemente sind in der Druckrichtung gesehen geometrisch sehr groß ausgebildet. Sie sind daher zur Stabilisierung ihrer relativen Lage zueinander über eine biegeeleastische, jedoch zugfeste bandartige Folie, nachstehend flexible Folie genannt, an Ihrer Druckaufnahmeseite miteinander verbunden.

Die Druckschrift US 2011 / 205161 A1 offenbart ein Fernbedienung gemäß dem Oberbegriff des Anspruchs 1.

Gemäß einem Aspekt der Erfindung, umfasst eine Fernbedienung eine erste Informationseinleseeinrichtung und eine zweite Informationseinleseeinrichtung, die jeweils eingerichtet sind, eine Information basierend auf einem Druck eines Benutzers in einer Druckrichtung einzulesen, ein der ersten Informationseinleseeinrichtung zugeordnetes erstes Druckaufnahmeelement und ein der zweiten Informationseinleseeinrichtung zugeordnetes zweites Druckaufnahmeelement, die jeweils eine Druckaufnahmeseite zum Aufnehmen des Druckes vom Benutzer und eine Druckabgabeseite zum Abgeben des aufgenommenen Druckes an die jeweilige Informationseinleseeinrichtung besitzen, und eine die Druckaufnahmeseiten der Druckaufnahmeelemente miteinander verbindende flexible Leiterplatte, auf der wenigstens ein kapazitiver Messaufnehmer ausgebildet ist, dessen Kapazität von der Lage eines Fingers des Benutzers relativ zur flexiblen Leiterplatte abhängig ist.

Mit der angegebenen Fernbedienung wird vorgeschlagen die eingangs genannte flexible Folie als flexible Leiterplatte auszuführen und dort einen kapazitiven Sensor unterzubringen, der dann als redundantes oder zusätzliches Eingabeelement auf der Fernbedienung zu den vorhandenen Druckaufnahmeelementen verwendet werden kann. Die flexible Leiterplatte dient auf diese Weise nicht nur als mechanisch stabilisierendes Element zu Stabilisierung der Lage der Druckaufnahmeelemente gegeneinander sondern auch als weiteres Eingabemittel zur Informationsaufnahme. Auf diese Weise wird die Funktionsvielfalt der eingangs genannten flexiblen Folie erweitert.

Gleichzeitig werden durch die Ausführung der flexiblen Folie als flexible Leiterplatte mit einem kapazitiven Sensor auf der angegebenen Fernbedienung zwei unterschiedliche Sensortypen zur Informationseingabe bereitgestellt, die die Ausfallsicherheit der Fernbedienung erhöhen.

Erfindungsgemäß umfasst die angegebene Fernbedienung ein erstes Tastenelement und ein zweites Tastenelement, die jeweils auf einer der Druckaufnahmeseiten der Druckelemente gegenüberliegenden Seite der flexiblen Leiterplatte auf diese aufgelegt sind. Die beiden Tastenelemente können von einem Benutzer zur Informationseingabe je nach Benutzertyp einfach berührt oder mit einer gewissen Kraft gedrückt werden. Je nach Kraftaufwand wird die eingegebene

Information dann entweder von den Informationseinleseeinrichtungen und/oder vom kapazitiven Sensor aufgenommen.

In einer besonderen Weiterbildung der angegebenen Fernbedienung weisen die Tastenelemente je eine Druckaufnahmeseite zur Aufnahme des Druckes vom Benutzer auf, die in einem druckfreien Zustand in einer Ebene liegen. Die Lage der Druckaufnahmeseite in einer Ebene ermöglicht es dem Benutzer seine Eingaben über den kapazitiven Sensor durch Wischbewegungen zu tätigen. Handelt es sich daher um einen Benutzer, der derartige Eingaben von seinen anderen elektronischen Geräten, wie beispielsweise seinem Smartphone gewöhnt ist, dann kann er diese Form der Eingabe intuitiv verwenden. Handelt es sich andererseits um einen Benutzer, der zur Informationseingabe eher das Drücken harter Tasten gewöhnt ist, dann erlaubt ihm dies die Fernbedienung ebenfalls über das Drücken der Druckaufnahmeelemente.

In einer anderen Weiterbildung der angegebenen Fernbedienung weisen die beiden Tastenelemente je eine Kante auf, die aufeinander zugerichtet mit einem Spalt von weniger als 1mm, vorzugsweise aneinander anliegend angeordnet sind. Der Spalt sollte einerseits so klein wie möglich sein, damit dieser den Benutzer bei der zuvor genannten Wischbewegung nicht stört. Das unmittelbare Aneinanderlegen der Tastenelemente kann jedoch ebenfalls zur Problemen führen, weil dann die Tastenelemente beim Drücken gegeneinander verkanten könnten.

Um das Risiko des Verkantens trotz sehr nah aneinander angeordneter Tastenelemente zu minimieren, können die Tastenelemente an der jeweiligen Kante in ihrer in der Druckrichtung gesehenen Dicke verjüngend ausgebildet sein. Auf diese Weise können sich die Tastenelemente beim Drücken untereinander schieben, wodurch ein Verkanten wirksam vermieden wird.

In einer noch anderen Weiterbildung der angegebenen Fernbedienung kann die flexible Leiterplatte mit den Druckaufnahmeelementen und mit den Tastenelementen klebend verbunden sein. Auf diese Weise werden sowohl die flexible Leiterplatte auf den Druckaufnahmeelementen als auch die Tastenelemente an der flexiblen Leiterplatte wirksam gehalten.

Erfindungsgemäß ist in der angegebenen Fernbedienung die flexible Leiterplatte wenigstens an einem der Tastenelemente winklig zur Druckrichtung gesehen formschlüssig gehalten. Auf diese Weise kann der flexiblen Leiterplatte in der Druckrichtung gesehen unterhalb der Tastenelemente eine eindeutige Position vorgegeben werden, mit der eventuelle Anzeigeelemente auf einer der flexiblen Leiterplatte gegenüberliegenden Seite der Tastenelemente ebenfalls richtig positioniert werden.

In einer weiteren Weiterbildung der angegebenen Fernbedienung weist die flexible Leiterplatte in der Druckrichtung eine Beschichtung unterhalb eines Übergangs zwischen den beiden Tastenelementen auf. Die Beschichtung erlaubt es farbliche Differenzen in dem oben genannten Spalt vor dem Benutzer zu verstecken. Ist beispielsweise die flexible Leiterplatte aufgrund einer geeigneten Materialwahl nur in einer hellen Farbe wie orange ausführbar und der oben genannte Spalt sehr groß, dann würde diese helle Farbe durch den Spalt durchscheinen. Die Beschichtung an dieser Stelle verhindert dies wirksam.

In einer besonderen Weiterbildung umfasst die angegebene Fernbedienung ein Steuerkreuz, wobei die beiden Tastenelemente umfänglich um das Steuerkreuz angeordnet sind. In der Regel hält ein Benutzer die Fernbedienung mit den Fingern und bedient das Steuerkreuz mit dem Daumen. Durch die Anordnung der Tastenelemente umfänglich um das Steuerkreuz kann dieser in einfacher Weise die Tastenelemente zum Wischen mit dem Daumen erreichen, um damit verbundene Funktionen zu steuern.

In einer besonders bevorzugten Weiterbildung der angegebenen Fernbedienung liegt auch das Steuerkreuz auf der flexiblen Leiterplatte auf. Auf diese Weise kann die zuvor genannte Kombination der mechanischen Druckeingabe von Informationen und der kapazitiven Eingabe von Informationen auf das Steuerkreuz erweitert werden.

Die oben beschriebenen Eigenschaften, Merkmale und Vorteile dieser Erfindung sowie die Art und Weise wie diese erreicht werden, werden verständlicher im Zusammenhang mit der folgenden Beschreibung der Ausführungsbeispiele, die im Zusammenhang mit der Zeichnung näher erläutert werden. Es zeigen:
- Fig. 1: eine Fernbedienung gemäß einem ersten Ausführungsbeispiel in einer perspektivischen Ansicht,
- Fig. 2: einen Innenteil der Fernbedienung aus Fig. 1 in einer perspektivischen Explosionsansicht,
- Fig. 3: eine flexible Leiterplatte in der Fernbedienung aus Fig. 2 in einer Draufsicht,
- Fig. 4: die flexible Leiterplatte aus Fig. 3 in einer Ansicht von unten,
- Fig. 5: eine Fernbedienung gemäß einem zweiten Ausführungsbeispiel in einer perspektivischen Ansicht,
- Fig. 6: einen Innenteil der Fernbedienung aus Fig. 5 in einer perspektivischen Explosionsansicht,
- Fig. 7: einen Innenteil der Tastenfeld 51 aus Fig. 6 in einer perspektivischen Explosionsansicht,
- Fig. 8: eine flexible Leiterplatte in der Fernbedienung aus Fig. 5 in einer Draufsicht,

In den Figuren werden gleiche technische Elemente mit gleichen Bezugszeichen versehen und nur einmal beschrieben. Die Figuren sind rein schematisch und geben vor allem nicht die tatsächlichen geometrischen Verhältnisse wieder.

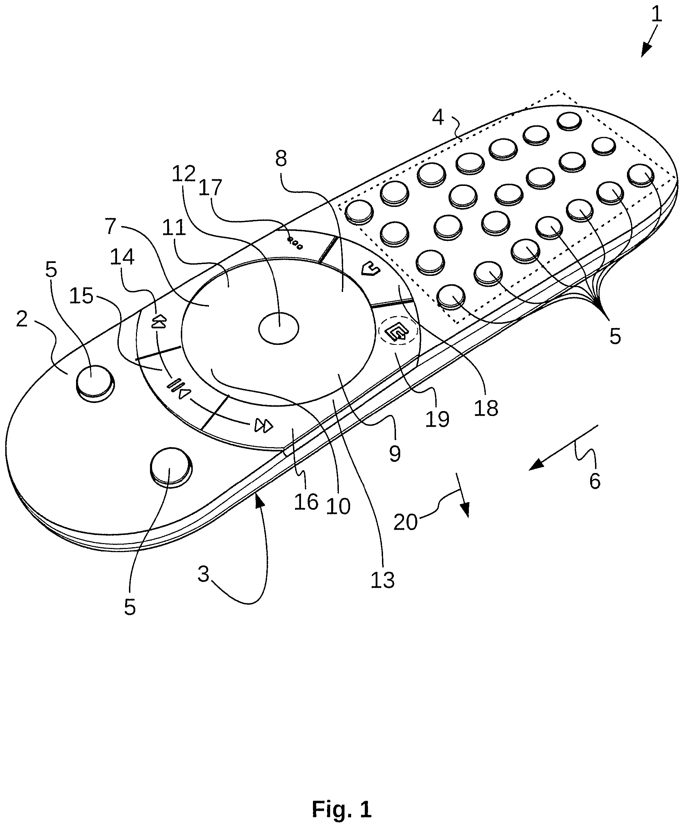

Es wird auf Fig. 1 Bezug genommen, die eine Fernbedienung 1 gemäß einem ersten Ausführungsbeispiel in einer perspektivischen Ansicht zeigt.

Die Fernbedienung 1 umfasst ein Gehäuse, das aus einer Oberschale 2 und einer Unterschale 3 zusammengesetzt ist, sowie ein Tastenfeld 4 mit einer Vielzahl von Tastenelementen 5. Von den Tastenelementen 5 im Tastenfeld 4 sind in den Figuren der Übersichtlichkeit halber nicht alle mit einem Bezugszeichen versehen.

In einer Blickrichtung 6 oberhalb des Tastenfeldes 4 ist ein Steuerkreuz 7 angeordnet, das ein erstes Tastenelement 8, ein zweites Tastenelement 9, ein drittes Tastenelement 10 und ein viertes Tastenelement 11 umfasst. Die vier Tastenelemente 8 bis 11 sind zur Bewegung eines Steuerelementes auf einem nicht weiter gezeigten elektronischen Gerät, das beispielsweise als Multimediagerät ausgeführt sein kann, vorgesehen und daher in den vier möglichen Bewegungsrichtungen umfänglich und im Abstand von 90° um eine Bestätigungstaste 12 angeordnet. Das Steuerkreuz 7 mit den vier Tastenelementen 8 bis 11 ist hier als kreisrunde Scheibe ausgebildet.

Das Steuerkreuz 7 ist von einem Tastenring 13 umfänglich umgeben. Die Tastenelemente des Tastenrings 13 unterscheiden sich von der Form her von den übrigen Tastenelementen 5 auf der Fernbedienung 1, wie beispielsweise im Tastenfeld 4. Ein erstes Tastenelement 14 des Tastenrings 13, ein zweites Tastenelement 15 des Tastenrings 13 und ein drittes Tastenelement 16 des Tastenrings 13 sind in der Blickrichtung 6 gesehen oberhalb des Steuerkreuzes 7 umfänglich um dieses angeordnet, während ein viertes Tastenelement 17 des Tastenrings 13, ein fünftes Tastenelement 18 des Tastenrings 13 und ein sechstes Tastenelement 19 des Tastenrings 13 in der Blickrichtung 6 gesehen unterhalb des Steuerkreuzes 7 umfänglich um dieses angeordnet sind.

Schließlich sind in Blickrichtung 6 oberhalb der ersten bis dritten Tastenelemente 14 bis 16 des Tastenrings 13 zwei weitere Tastenelemente 5 angeordnet, die in derselben Weise ausgeführt sind, wie die Tastenelemente 5 im Tastenfeld 4.

Mit der Fernbedienung 1 soll der Betrieb des nicht weiter dargestellten elektronischen Gerätes, wie beispielsweise einer Set Top Box gesteuert werden. Hierzu gibt ein Benutzer mittels der Tasten auf der Oberschale 2 der Fernbedienung 1 Steuerbefehle als Informationen in die Fernbedienung 1 ein, die dann mittels eines nicht weiter gezeigten Übertragers an das zu steuernde elektronische Gerät übertragen werden.

Hierbei legt der Benutzer normalerweise die Fernbedienung 1 mit der Unterschale 3 in seine Finger, während er mit dem Daumen die einzelnen Tastenelemente auf der Oberschale 2 zur Informationseingabe bedient. Zur Informationseingabe soll der Benutzer einerseits ein beliebiges der Tastenelemente auf der Oberschale 2 in einer Druckrichtung 20 in einen durch die Oberschale 2 und die Unterschale 3 abgegrenzten Innenraum des Gehäuses drücken können. Andererseits soll der Benutzer zur Informationseingabe auch das Steuerkreuz 7 oder den Tastenring 13 ohne Druck berühren und auf den entsprechenden Tastenelementen mit dem Daumen hin- und herfahren können, was nachstehend Wischen genannt wird.

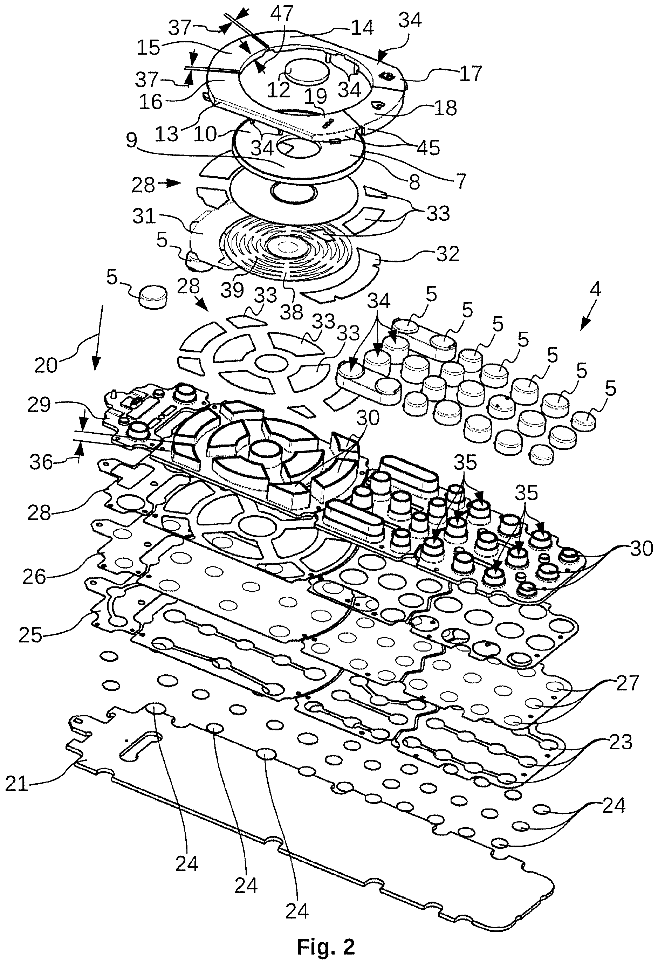

Die Informationseingabe per Druck wird nachstehend anhand der Fig. 2 näher erläutert, die eine Explosionsansicht der inneren Komponenten der Fernbedienung 1 zeigt.

Die Fernbedienung 1 umfasst im Inneren eine Leiterplatte 21, auf der nicht weiter dargestellte galvanisch getrennte Schaltkontakte ausgebildet sind, die mittels elektrisch leitfähigen Kontaktdomen 24 kurzgeschlossen werden können. Von diesen Kontaktdomen 24 sind in Fig. 2 der Übersichtlichkeit halber nicht alle mit einem Bezugszeichen versehen.

Die Kontaktdome 24 sind mit ihrem Randbereich in einer an sich bekannten Weise auf der Leiterplatte 21 auf einen Schaltkontakt aufgelegt. Durch Drücken der Tastenelemente 5, 8 bis 11 und 14 bis 19 auf der Fernbedienung 1 in der Druckrichtung 20 werden die Kontaktdome 24 dann mittig gegen einen weiteren Schaltkontakt auf der Leiterplatte 21 niedergedrückt. Die so kurzgeschlossenen Schaltkontakte leiten nun einen elektrischen Strom, der dann ausgewertet werden kann um zu bestimmen, welches der Tastenelemente 5, 8 bis 11 und 14 bis 19 der Benutzer auf der Fernbedienung 1 gedrückt hat. Die Schaltkontakte dienen daher gemeinsam mit den Kontaktdomen 24 als Informationseinleseeinrichtungen, mit der die Informationseingabe des Benutzers in eine elektrische Schaltung auf der Leiterplatte 21 eingelesen werden kann.

Um die Kontaktdome 24 mechanisch mit den Tastenelementen 5, 8 bis 12 und 14 bis 19 zu verbinden, ist auf die Leiterplatte 21 eine Abstandsfolie 25 mit Durchgangsöffnungen 23 aufgelegt. Von diesen Durchgangsöffnungen 23 sind in Fig. 2 der Übersichtlichkeit halber nicht alle mit einem eigenen Bezugszeichen versehen. Auf die Abstandsfolie 25 ist eine Haltefolie 26 aufgelegt, die die Kontaktdome 24 hält. Die Haltepunkte 27 auf der Haltefolie 26 sind durch kleine Kreise angedeutet, von denen in Fig. 2 der Übersichtlichkeit halber nicht alle mit einem Bezugszeichen versehen sind. Die Haltepunkte 27 liegen in der Druckrichtung 20 gesehen genau über den Durchgangsöffnungen 23 der Abstandsfolie 25. Im auf die Abstandsfolie 25 aufgelegten Zustand der Haltefolie 26 sind die einzelnen Kontaktdome 24 daher in die Durchgangsöffnungen 23 eingeführt und können darin zum Kurzschluss der Schaltkontakte niedergedrückt werden.

Auf die Abstandsfolie 25 ist eine Klebefolie 28 aufgebracht, über die auf der Abstandsfolie 25 eine Gummimatte 29 gehalten ist. Auf dieser Gummimatte 29 sind eine Vielzahl von Druckaufnahmeelementen 30 ausgebildet, die einerseits einen auf die einzelnen Tastenelemente 5, 8 bis 12 und 14 bis 19 ausgeübten Druck in der Druckrichtung 20 aufnehmen und damit die Kontaktdome 24 in der oben beschriebenen Weise niederdrücken. Andererseits stellen die Druckaufnahmeelemente 30 die Tastenelemente 5, 8 bis 12 und 14 bis 19 gegen die Druckrichtung 20 in eine Ausgangslage zurück, wenn der Druck auf die Tastenelemente 5, 8 bis 12 und 14 bis 19 wieder nachlässt. Alle Tastenelemente 5 außerhalb des Tastenrings 13 sind unmittelbar auf den Druckaufnahmeelementen 30 auf der Gummimatte 29 kraftschlüssig gehalten.

Die Tastenelemente 14 bis 19 des Tastenrings 13 und die Tastenelemente 8 bis 12 innerhalb des Tastenrings 13 sind demgegenüber über eine erste flexible Folie 31 und eine zweite flexible Folie 32 auf den Druckaufnahmeelementen 30 gehalten. Um die oben genannte alternative Informationseingabe per Wischen zu ermöglichen, ist die erste flexible Folie 31 hierbei als flexible Leiterplatte ausgeführt und wird daher nachstehend flexible Leiterplatte 31 genannt. Auf technische Details zur flexiblen Leiterplatte wird an späterer Stelle eingegangen.

Die flexible Leiterplatte 31 und die zweite flexible Folie 32 sind über eine weitere Klebefolie 28 aus mehreren nicht miteinander zusammenhängenden Klebeelementen 33 auf die Druckaufnahmeelemente 30 aufgeklebt. Von diesen Klebeelementen 33 sind in Fig. 2 der Übersichtlichkeit halber nicht alle mit einem eigenen Bezugszeichen versehen.

Auf der den Druckaufnahmeelementen 30 gegenüberliegenden Seite der flexiblen Leiterplatte 31 und der zweiten flexiblen Folie 32 sind die Tastenelemente 14 bis 19 des Tastenrings 13 und die Tastenelemente 8 bis 12 innerhalb des Tastenrings 13 über eine weitere Klebefolie 28 mit Klebeelementen 33 aufgeklebt, von denen der Übersichtlichkeit halber ebenfalls nicht alle mit einem eigenen Bezugszeichen versehen sind.

Zur Informationseingabe per Druck drückt der Benutzer auf der in seinen Fingern liegenden Fernbedienung 1 eines der Tastenelemente 5, 8 bis 12 oder 14 bis 19 in der Druckrichtung 20 gesehen auf der Oberseite, nachstehend Druckaufnahmeseite 34 der Tastenelemente genannt. Die Druckaufnahmeseiten 34 der einzelnen Tastenelemente 5, 8 bis 12 und 14 bis 19 sind in der Fig. 2 der Übersichtlichkeit halber nicht alle mit einem Bezugszeichen versehen.

Der Teil des durch den Benutzer ausgeübten Druckes auf die Druckaufnahmeseiten 34 der Tastenelemente 5, 8 bis 12 und 14 bis 19, der in die Druckrichtung 20 zeigt, wird nun an eine Druckaufnahmeseite 35 des dem jeweiligen Tastenelement 5, 8 bis 12 und 14 bis 19 zugeordneten Druckaufnahmeelementes 30 übertragen. Mit diesem Teil des Druckes werden der oben genannte entsprechende Kontaktdom 24 niedergedrückt und die Schaltkontakte kurzgeschlossen.

Ein zweiter Teil des durch den Benutzer ausgeübten Druckes auf die Druckaufnahmeseiten 34 der Tastenelemente 5, 8 bis 12 und 14 bis 19, der rechtwinklig zur Druckrichtung 20 zeigt, verschiebt das jeweilig gedrückte Tastenelement 5, 8 bis 12 und 14 bis 19 zur Seite und verkippt das entsprechende Druckaufnahmeelement 30. Dies kann dazu führen, dass die Tastenelemente 5, 8 bis 12 und 14 bis 19 in der Fernbedienung 1 verkanten. Die Wahrscheinlichkeit eines derartigen Verkippens nimmt mit einer steigenden Höhe 36 der Druckaufnahmeelemente 30 zu. Von diesen Höhen 36 sind in Fig. 2 der Übersichtlichkeit halber nicht alle mit einem eigenen Bezugszeichen versehen. Die Druckaufnahmeelemente 30 und ihre Höhen 36 können jedoch gerade in Fernbedienungen für Multimediageräte nicht beliebig klein gewählt werden. Diese Art Fernbedienungen müssen aufgrund ihrer Griffigkeit in gewisser Weise bauchig ausgeführt sein, was einen hohen Abstand zwischen Unterschale 3 und Oberschale 2 bedingt. Diesen hohen Abstand müssen die Druckaufnahmeelemente 30 zwischen der Leiterplatte 21 in der Unterschale 3 und den Tastenelementen 5, 8 bis 12 und 14 bis 19 an der Oberschale 2 überbrücken.

Vom Benutzer muss daher eine gewisse Fähigkeit vorausgesetzt werden, die Tasten exakt in der Druckrichtung 20 zu drücken. Für motorisch eingeschränkte Benutzer, bei denen das nicht vorausgesetzt werden kann, wie beispielsweise ältere Benutzer, können normalerweise geeignete Führungen der Tastenelemente 5, 8 bis 12 und 14 bis 19 diese verkippenden Kräfte aufnehmen und das Verkanten vermeiden.

Jedoch kann es aus gestalterischen oder technischen Gründen notwendig sein, einige der Tastenelemente 5, 8 bis 12 und 14 bis 19 mit einem sehr geringen Abstand so nah beieinander anzuordnen, dass eine geeignete Führung nicht mehr untergebracht werden kann. Dies ist in der in Fig. 1 gezeigten Fernbedienung bei den Tastenelementen 14 bis 19 des Tastenringes 13 und den Tastenelementen 8 bis 12 innerhalb des Tastenringes 13 der Fall. Nachstehend werden zur weiteren Erläuterung des Ausführungsbeispiels die Tastenelemente 14 bis 19 des Tastenrings 13 betrachtet. Dies soll jedoch nicht einschränkend verstanden werden, denn die Ausführungen lassen sich auf jedes beliebige Tastenelement in der Fernbedienung 1 übertragen, das so nah bei einem anderen Tastenelement gelagert werden soll, dass eine Führung zur Kippvermeidung nicht mehr untergebracht werden kann, wie beispielsweise der Bestätigungstaste 12.

Die Tastenelemente 14 bis 19 des Tastenrings 13 umgeben das kreisförmige Steuerkreuz 9 wie ein Umkreis.

Dabei sind das erste Tastenelement 14 und das vierte Tastenelement 17 des Tastenrings 13 sowie das dritte Tastenelement 16 und das sechste Tastenelement 19 des Tastenrings 19 jeweils einstückig als eine Tastenwippe ausgeführt. Jede Tastenwippe weist Stützzapfen 34 auf, die in die Unterschale 3 einpressbar sind. Wird ein Tastenelement 14, 16, 17, 19 einer Tastenwippe in der Druckrichtung 20 gedrückt, dann verhindern die Stützfüßchen 34, dass gleichzeitig das andere Tastenelement 14, 16, 17, 19 an der Tastenwippe ebenfalls mit nach unten gedrückt wird.

Zwischen den Tastenwippen und damit den Tastenelementen 14, 16, 17, 19 sind im Tastenring 13 das zweite und fünfte Tastenelement 15, 18 sehr nah beabstandet mit jeweiligen Spalten 37 von weniger als 1mm gehalten. Von diesen Spalten 37 sind in Fig. 2 der Übersichtlichkeit halber nicht alle mit einem Bezugszeichen versehen. Weil das zweite und fünfte Tastenelement 15, 18 zwischen den Tastenwippen aufgrund der geringen Spalte 37 nicht geführt gelagert werden kann oder soll, könnten diese beiden Tastenelemente 15, 18 grundsätzlich in der Fernbedienung verkanten, wenn der Benutzer diese Tastenelemente 15, 18 nicht exakt in der Druckrichtung 20 sondern winklig dazu drückt.

Hier greifen die Folien 31, 32 an, die Druckkräfte des Benutzers winklig zur Druckrichtung 20 aufnehmen und so dafür sorgen, dass auf die einzelnen Druckaufnahmeelemente 30 beim Drücken des zweiten und fünften Tastenelementes 15, 18 nur Druckkräfte in der Druckrichtung 20 übertragen werden. Auf diese Weise wird ein Verkippen der Druckaufnahmeelemente 30 wirksam vermieden, unabhängig davon, welche Höhe 36 sie aufweisen.

Sollten die Druckaufnahmeelemente 30 unterhalb des zweiten und fünften Tastenelementes 15, 18 trotz der Folien 31, 32 dennoch geringfügig verkippen, so kann ein damit verbundenes Verkanten mit den Tastenwippen im Tastenring 13 dadurch vermieden werden, dass eine Dicke 47 der Tastenelemente 14 bis 19 im Tastenring 13 zu den einzelnen Spalten 37 hin verjüngend ausgebildet ist. Sollten die Tastenelemente 14 bis 19 beim Drücken durch den Benutzer dennoch verkippen, dann können sie sich unter die jeweils benachbarten Tastenelemente 14 bis 19 im Tastenring 13 schieben, ohne an diese anzustoßen.

Um die Folien 31, 32 in einer vorbestimmten Lage an der in Druckrichtung 20 gesehenen Unterseite der Tastenelemente 14 bis 19 des Tastenrings 13 zu halten, können zumindest an einigen der Tastenelemente 14 bis 19 Wände 45 ausgeführt sein, mit denen die Folien 31, 32 winklig zur Druckrichtung 20 gesehen formschlüssig gehalten werden können. Von diesen Wänden 45 sind in der Ansicht der Fig. 2 nicht alle zu erkennen.

Die erste Folie und damit die flexible Leiterplatte 31 trägt in der vorliegenden Ausführung einen kapazitiven Sensor, um die alternative Informationseingabe per Wischen zu ermöglichen, d.h. dass die flexible Leiterplatte 31 mehrere Kondensatorplatten 38 trägt, die durch zick-zack-förmige dielektrische Spalte 39 voneinander getrennt sind. Von diesen Kondensatorplatten 38 und den dielektrischen Spalten 39 sind in Fig. 2 der Übersichtlichkeit halber nicht alle mit einem Bezugszeichen versehen.

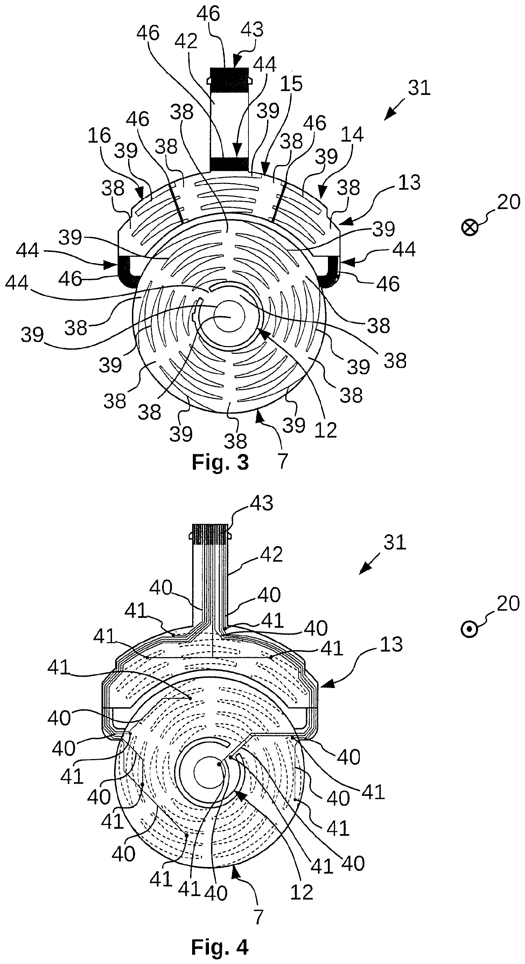

Die flexible Leiterplatte 31 soll nachstehend anhand der Fig. 3 und 4 näher beschrieben werden, die die flexible Leiterplatte 31 entsprechend in einer Draufsicht und in einer Ansicht von unten zeigen.

Die flexible Leiterplatte 31 ist in vier Bereiche unterteilt. Ein erster Bereich trägt das erste bis dritte Tastenelement 14 bis 16 des Tastenrings 13 und ist deshalb mit dem Bezugszeichen des Tastenrings 13 angedeutet. Ein zweiter Bereich trägt das Steuerkreuz 7 und ist deshalb mit dem Bezugszeichen des Steuerkreuzes 7 angedeutet. Ein dritter Bereich 12 trägt die Bestätigungstaste 12 und ist deshalb mit dem Bezugszeichen der Bestätigungstaste 12 angedeutet. Ein vierter Bereich ist ein Flachbandkabel 42, auf dem eine elektrische Schnittstelle 43 ausgebildet ist, in denen elektrische Leiterbahnen 40 enden. Die einzelnen Bereiche 7, 12, 13, 42 sind durch Verbindungselemente 44 miteinander verbunden.

Auf der in der Druckrichtung 20 gesehenen Oberseite der flexiblen Leiterplatte 31, die in Fig. 3 abgebildet ist, sind die einzelnen Kondensatorplatten 38, die durch die zick-zack-förmigen dielektrischen Spalte 39 voneinander getrennt sind, in den Bereichen des Tastenrings 13, des Steuerkreuzes 7 und der Bestätigungstaste 12 ausgebildet. Gegeneinander weisen die einzelnen Kondensatorplatten 38 in an sich bekannter Weise eine bestimmte Kapazität auf, die über Durchkontaktierungen 41 zur in Fig. 4 gezeigten Unterseite der flexiblen Leiterplatte 31, die elektrischen Leiterbahnen und die elektrische Schnittstelle 43 bestimmt werden kann. Die Schnittstelle 43 kann beispielsweise an die Leiterplatte 21 angeschlossen werden, um die Kapazität der Kondensatorplatten 38 auszuwerten und informationstechnisch weiter zu verarbeiten. Weil die Kapazität in an sich bekannter Weise auch von der Länge der dielektrischen Spalte 39 abhängig ist, sind diese durch Verlängerungsmaßnahmen, wie die gezeigte zick-zack-Form, so lang wie möglich ausgeführt.

Bewegt ein Benutzer seinen Daumen über die Druckaufnahmefläche 34 des Tastenrings 13, des Steuerkreuzes 7 oder der Bestätigungstaste 12, dann verändert sich diese bestimmte Kapazität zwischen den Kondensatorplatten 38 in an sich bekannter Weise, so dass sich die Lage des Daumens des Benutzers bestimmen lässt. Die Technik hierzu ist beispielsweise aus der DE 10 2010 003 575 A1 bekannt und soll nicht weiter erläutert werden.

Daher ist auf der Fernbedienung 1 nicht nur eine Informationseingabe per Druck sondern auch eine Informationseingabe per Wischen zumindest über einen Teil der Tastenelemente auf der Fernbedienung 1 möglich. Auf diese Weise kann die Fernbedienung einem breiteren Benutzerpublikum angeboten werden, beispielsweise Benutzern, die eine Eingabe von Informationen mittels Hubtasten gewohnt sind und Benutzern, die eine Eingabe mittels Finger-Wischbewegungen gewohnt sind. Auch die Ausfallsicherheit ist durch die Fernbedienung 1 der vorliegenden Ausführung verbessert, weil redundant zwei Informationseingabesysteme vorgesehen sind. Dabei übernimmt das redundante Informationseingabesystem mittels kapazitiver Eingabetechnik gleichzeitig eine Stabilisierungsfunktion der einzelnen Hubtasten in der Fernbedienung 1.

Damit der Benutzer seinen Daumen über die Druckaufnahmefläche 34 des Tastenringes 13 möglichst ohne Hindernisse gleiten lassen kann, sind die Spalte 37 in der oben beschriebenen Weise so klein wie möglich ausgeführt. Ferner liegen die Druckaufnahmeflächen 34 aller Tastenelemente 14 bis 19 des Tastenrings 13 in einem druckfreien Zustand in einer gemeinsamen Ebene.

Ferner können auf der Oberseite der flexiblen Leiterplatte 31 im Bereich der Spalte 37 zwischen den einzelnen Tastenelementen Beschichtungen 46 vorhanden sein. Die Beschichtungen 46 sind in einer Farbe wie schwarz ausgeführt, die durch den Spalt 37 nicht zu erkennen ist. Ist ein Verbindungselement 44 jedoch klein genug, um optisch dem Benutzer nicht aufzufallen, dann kann auf die Beschichtung auch verzichtet werden. Dies ist beispielsweise bei dem Verbindungselement 44 zwischen dem Steuerkreuz 7 und der Bestätigungstaste 12 der Fall.

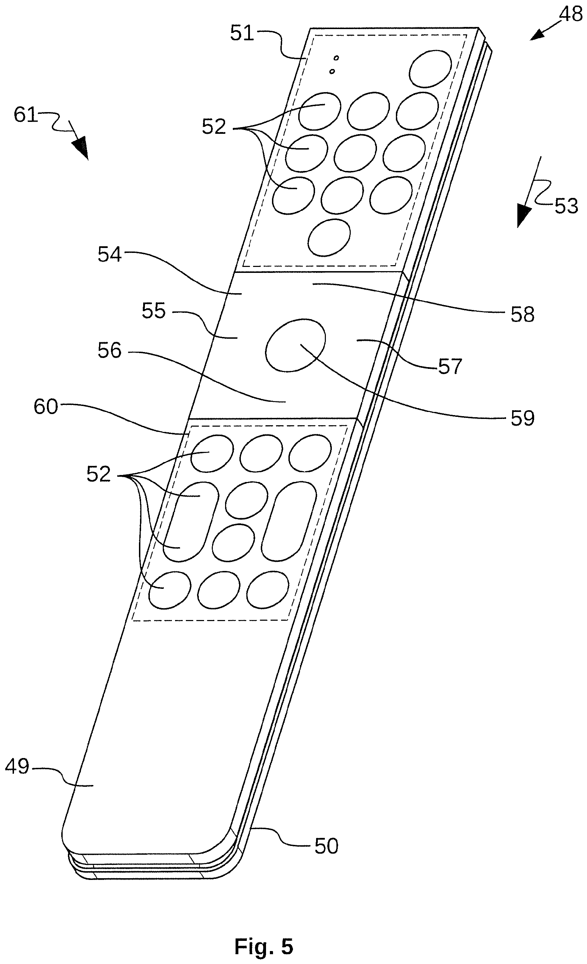

Es wird auf Fig. 5 Bezug genommen, die eine Fernbedienung 48 gemäß einem zweiten Ausführungsbeispiel in einer perspektivischen Ansicht zeigt.

Die Fernbedienung 48 umfasst ein Gehäuse, das aus einer Oberschale 49 und einer Unterschale 50 zusammengesetzt ist. Auf der Fernbedienung 48 ist ein Tastenfeld 51 mit einer Vielzahl von Tastenelementen 52 angeordnet. Von den Tastenelementen 52 des ersten Tastenfeldes 51 sind in den Figuren der Übersichtlichkeit halber nicht alle mit einem Bezugszeichen versehen. In einer Blickrichtung 53 gesehen unterhalb des ersten Tastenfeldes 51 ist ein Steuerkreuz 54 angeordnet, das in Form eines Quadrates ausgebildet ist. An dem Steuerkreuz 54 bilden die Bereiche an den Kanten entsprechend ein erstes Tastenelement 55, ein zweites Tastenelement 56, ein drittes Tastenelement 57 und ein viertes Tastenelement 58. Die vier Tastenelemente 55 bis 58 sind zur Bewegung eines Steuerelementes auf dem bereits genannten nicht weiter gezeigten elektronischen Gerät vorgesehen. Daher sind die vier Tastelelemente 55 bis 58 in den vier möglichen Bewegungsrichtungen umfänglich und im Abstand von 90° um eine kreisförmige Bestätigungstaste 59 angeordnet. Schließlich ist in Blickrichtung 53 unterhalb des Steuerkreuzes 54 ein zweites Tastenfeld 60 angeordnet, das grundsätzlich in derselben Weise ausgeführt ist, wie das erste Tastenfeld 51. Im Unterschied zum ersten Tastenfeld 51 sind im zweiten Tastenfeld 60 einige der Tastenelementen 52 miteinander verbunden. Ferner sind die Tastenelemente 52 im zweiten Tastenfeld 60 geringfügig anders angeordnet, als im ersten Tastenfeld 51.

Die Tastenelemente 52 können in einer Druckrichtung 61 rechtwinklig zur Blickrichtung 53 in die Fernbedienung 48 hinein drückbar.

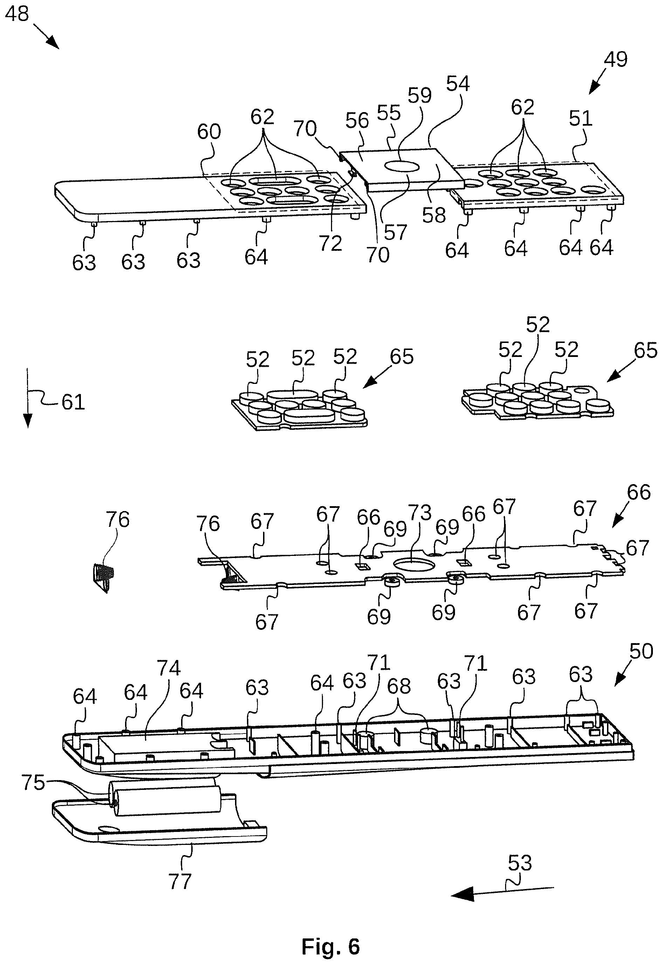

Die Fernbedienung 48 wird nachstehend anhand der Fig.6 näher erläutert.

Wie in Fig. 6 zu sehen, ist die Oberschale 49 mehrteilig aufgebaut. Durch die Oberschale 49 hindurch sind in der Druckrichtung 61 Tastenführöffnungen 62 geführt, in denen die Tastenelemente 52 der Tastenfelder 51, 60 geführt sind. Von diesen Tastenführöffnungen 62 sind der Übersichtlichkeit halber nicht alle mit einem eigenen Bezugszeichen versehen.

In Druckrichtung 61 an der Unterseite der Oberschale 49 sowie an der Oberseite der Unterschale 50 sind eine Vielzahl von Zapfen 63 und Hülsen 64 angeordnet, von denen der Übersichtlichkeit halber nicht alle mit einem eigenen Bezugszeichen versehen sind. Zu jedem vorhandenen Zapfen 63 auf der Oberschale 49 oder der Unterschale 50 ist entsprechend auf der anderen Seite, das heißt auf der Unterschale 50 beziehungsweise auf der Oberschale 60 grundsätzlich ortsgleich eine Hülsen 64 angeordnet, so dass beim Aufsetzen der Oberschale 49 auf die Unterschale 50 in jede Hülse 64 ein Zapfen 63 einführbar ist. Dabei werden die Zapfen 63 kraftschlüssig in den Hülsen 54 gehalten, so dass die Oberschale 49 allein durch die Vielzahl an kraftschlüssigen Verbindungen ohne weitere Verbindungsmittel wie Schrauben, Kleber, Haken oder dergleichen zusammengehalten wird. Dieser Zusammenhalt kann durch leichtes Versetzen der Zapfen 63 und Hülsen 64 zueinander noch verstärkt werden, weil sich die Zapfen 63 und Hülsen 64 so gegenseitig noch verspannen.

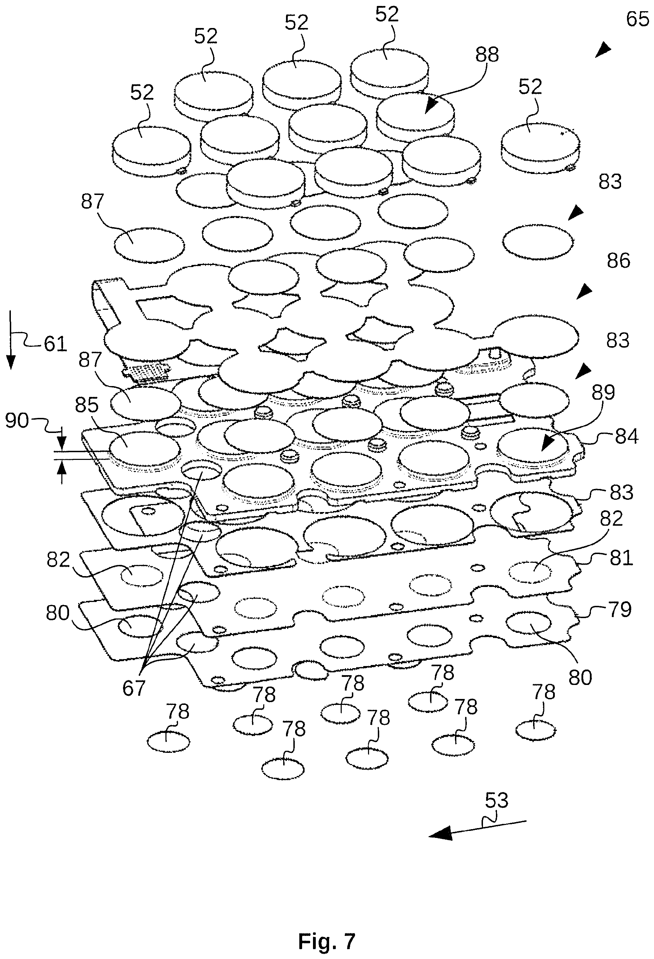

Die Tastenelemente 52 sind auf Tastenträgern 65 derart getragen, das in jede Tastenführöffnung 62 ein Tastenelement 52 einsetzbar ist. Für jedes Tastenfeld 51, 60 ist ein eigener Tastenträger 65 angeordnet. Die Tastenträger 65 werden später anhand des Tastenträgers 65 für das erste Tastenfeld im Zusammenhang mit Fig. 7 näher beschrieben.

Auf einer in der Druckrichtung 61 gesehenen Unterseite der Tastenträger 65 ist eine Leiterplatte 66 angeordnet. Durch diese Leiterplatte 66 sind Zapfenführungen 67 in Form von Durchgangsöffnungen oder Kerben geführt, in denen die Zapfen 64 der zuvor beschriebenen Zapfen-Hülsen-Verbindung aufgenommen sind. Von diesen Zapfenführungen 67 sind der Übersichtlichkeit halber nicht alle mit einem eigenen Bezugszeichen versehen. Über die Zapfenführungen 67 wird die Leiterplatte 66 an den Zapfen 64 in einer Ebene senkrecht zur Druckrichtung 61 formschlüssig zwischen der Oberschale 49 und der Unterschale 50 gehalten.

Auf der Leiterplatte 66 ist ein nicht weiter zu sehender elektrischer Schaltkreis vorhanden, mit der eine von einer Betätigung der Tasten 52 oder des Steuerkreuzes 54 abhängige Information elektrisch erfasst und an das bereits genannte elektronische Gerät zu dessen Steuerung versendet wird. Auf die Versendung der Informationen soll nachstehend nicht weiter eingegangen zu werden.

Eine Betätigung des Steuerkreuzes 54 wird in der vorliegenden Ausführung magnetisch erfasst. Hierzu sind auf der Oberseite der Unterschale 50 vier Lagerschalen 68 angeordnet, in die je ein Ankermagnet 69 eingesetzt ist. Von den Lagerschalen 68 auf der Unterschale 50 sind in der Perspektive der Fig. 6 nicht alle zu sehen. Auf einer in Druckrichtung 61 gesehenen Unterseite des Steuerkreuzes 54 sind vier entsprechend den Lagerschalen 68 auf der Unterschale 50 und den Ankermagneten 69 nicht zu sehende Lagerschalen und darin aufgenommene Gebermagnete derart angeordnet, dass in einem Zustand, in dem die Oberschale 49 auf die Unterschale 50 aufgesetzt ist, je ein Gebermagnet gegenpolig auf einem Ankermagnet 69 liegt und das Steuerkreuz 54 von der Unterschale 50 magnetisch weggedrückt wird. Zur Bewegungsbegrenzung des Steuerkreuzes 54 aufgrund dieser magnetischen Kraft sind am Steuerkreuz 54 entsprechend Begrenzungsnasen 70 ausgebildet. Zur Betätigung kann das Steuerkreuz 54 so entgegen der magnetischen Kraft in Druckrichtung 61 an den einzelnen Tastenelemente 55 bis 58 gedrückt werden. Wird die Druckkraft gelöst, stellt die magnetische Kraft das Steuerkreuz 54 in eine Ausgangsstellung zurück. Zur Führung der Druckbewegung sind zwei Führungsschienen 71 angeordnet, in denen je eine Führungsnase 72 geführt ist, von der in der Perspektive der Fig. 6 nur eine zu sehen ist. Das Steuerkreuz 54 selbst ist hierbei in einer Steuerkreuzführungsöffnung 73 über ein Führungselement geführt, das an der in Druckrichtung 61 gesehenen Unterseite des Steuerkreuzes 54 angeordnet und in der Perspektive der Fig. 6 nicht zu sehen ist. Zur Auswertung einer Betätigung des Steuerkreuzes 54 sind auf der Leiterplatte 66 nicht zu sehende Magnetfeldsensoren angeordnet. Diese Erfassen eine Magnetfeldänderung, die durch die Gebermagnete an der Unterseite des Steuerkreuzes 54 durch die Bewegung hervorgerufen wird und ermöglichen so, eine entsprechende Betätigungsinformation an das bereits genannte elektronische Gerät zu senden.

Zur Energieversorgung der Leiterplatte 66 und damit der Fernbedienung 48 sind in einem Batteriefach 74 auf der Unterschale 50 zwei Batterien 75 aufgenommen. Zur mechanischen Fixierung der Batterien sind in dem Batteriefach 74 zusätzlich Federkontaktelemente 76 aufgenommen, die metallisch sind und so einen elektrischen Schaltkreis zwischen der Leiterplatte 66 und den Batterien 75 schließen. Das Batteriefach 74 ist an der in Druckrichtung 51 gesehenen Unterseite der Unterschale 50 mit einem Deckel 77 verschlossen.

Nachstehend wird die Erfassung der Druckbetätigung der Tastenelemente 52 der beiden Tastenfelder 51, 60 anhand des ersten Tastenfeldes 51 erläutert. Hierzu wird auf Fig. 7 Bezug genommen, die den zum ersten Tastenfeld 51 gehörenden Tastenträger 65 in einer perspektivischen Explosionsansicht zeigt. Der Tastenträger 65 für das zweite Tastenfeld 60 ist analog aufgebaut und wird nachstehend der Kürze halber nicht extra beschrieben.

Analog zur Leiterplatte 21 der Fernbedienung 2 des ersten Ausführungsbeispiels sind auf der Leiterplatte 66 der Fernbedienung 48 des zweiten Ausführungsbeispiels nicht weiter dargestellte galvanisch getrennte Schaltkontakte ausgebildet sind, die mittels elektrisch leitfähigen Kontaktdomen 78 kurzgeschlossen werden können. Von diesen Kontaktdomen 78 sind in Fig. 7 der Übersichtlichkeit halber nicht alle mit einem Bezugszeichen versehen.

Die Kontaktdome 78 sind mit ihrem Randbereich in einer an sich bekannten Weise auf der Leiterplatte 66 auf einen Schaltkontakt aufgelegt. Durch Drücken der Tastenelemente 52 auf der Fernbedienung 48 in der Druckrichtung 61 werden die Kontaktdome 24 dann mittig gegen einen weiteren Schaltkontakt auf der Leiterplatte 66 niedergedrückt. Die so kurzgeschlossenen Schaltkontakte leiten nun einen elektrischen Strom, der dann ausgewertet werden kann um zu bestimmen, welches der Tastenelemente 52 der Benutzer auf der Fernbedienung 48 gedrückt hat. Die Schaltkontakte dienen daher gemeinsam mit den Kontaktdomen 78 als Informationseinleseeinrichtungen, mit der die Informationseingabe des Benutzers in die elektrische Schaltung auf der Leiterplatte 66 eingelesen werden kann.

Um die Kontaktdome 78 mechanisch mit den Tastenelementen 52 zu verbinden, ist auf die Leiterplatte 66 eine Abstandsfolie 79 mit Durchgangsöffnungen 80 aufgelegt. Von diesen Durchgangsöffnungen 80 sind in Fig. 7 der Übersichtlichkeit halber nicht alle mit einem eigenen Bezugszeichen versehen. Diese Durchgangsöffnungen 80 für die Kontaktdome 78 sind gedanklich von den bereits erläuterten Zapfenführungen 67 zu trennen. Auf die Abstandsfolie 79 ist eine Haltefolie 81 aufgelegt, die die Kontaktdome 78 hält. Die Haltepunkte 82 auf der Haltefolie 81 sind durch kleine Kreise angedeutet, von denen in Fig. 7 der Übersichtlichkeit halber nicht alle mit einem Bezugszeichen versehen sind. Die Haltepunkte 82 liegen in der Druckrichtung 61 gesehen genau über den Durchgangsöffnungen 80 der Abstandsfolie 79. Im auf die Abstandsfolie 79 aufgelegten Zustand der Haltefolie 81 sind die einzelnen Kontaktdome 78 daher in die Durchgangsöffnungen 80 eingeführt und können darin zum Kurzschluss der Schaltkontakte niedergedrückt werden.

Auf die Abstandsfolie 79 ist eine Klebefolie 83 aufgebracht, über die auf der Abstandsfolie 79 eine Gummimatte 84 gehalten ist. Auf dieser Gummimatte 84 sind eine Vielzahl von Druckaufnahmeelementen 85 ausgebildet, die einerseits einen auf die einzelnen Tastenelemente 52 ausgeübten Druck in der Druckrichtung 61 aufnehmen und damit die Kontaktdome 78 in der oben beschriebenen Weise niederdrücken. Andererseits stellen die Druckaufnahmeelemente 85 die Tastenelemente 52 gegen die Druckrichtung 61 in eine Ausgangslage zurück, wenn der Druck auf die Tastenelemente 52 wieder nachlässt.

Die Tastenelemente 52 sind über eine flexible Folie 86 auf den Druckaufnahmeelementen 85 gehalten. Die flexible Folie 86 ist hierbei als flexible Leiterplatte ausgeführt und wird daher nachstehend flexible Leiterplatte 86 genannt. Auf technische Details zur flexiblen Leiterplatte 86 wird an späterer Stelle eingegangen.

Die flexible Leiterplatte 86 sind über eine weitere Klebefolie 83 aus mehreren nicht miteinander zusammenhängenden Klebeelementen 87 auf die Druckaufnahmeelemente 30 aufgeklebt. Von diesen Klebeelementen 33 sind in Fig. 7 der Übersichtlichkeit halber nicht alle mit einem eigenen Bezugszeichen versehen.

Auf der den Druckaufnahmeelementen 85 gegenüberliegenden Seite der flexiblen Leiterplatte 86 sind die Tastenelemente 52 über eine weitere Klebefolie 83 mit Klebeelementen 87 aufgeklebt, von denen der Übersichtlichkeit halber ebenfalls nicht alle mit einem eigenen Bezugszeichen versehen sind.

Zur Informationseingabe per Druck drückt der Benutzer auf der in seinen Fingern liegenden Fernbedienung 48 eines der Tastenelemente 52 in der Druckrichtung 61 gesehen auf der Oberseite, nachstehend Druckaufnahmeseite 88 der Tastenelemente genannt. Die Druckaufnahmeseiten 34 der einzelnen Tastenelemente 52 sind in der Fig. 7 der Übersichtlichkeit halber nicht alle mit einem Bezugszeichen versehen.

Der Teil des durch den Benutzer ausgeübten Druckes auf die Druckaufnahmeseiten 34 der Tastenelemente 52, der in die Druckrichtung 61 zeigt, wird nun an eine Druckaufnahmeseite 89 des dem jeweiligen Tastenelement 52 zugeordneten Druckaufnahmeelementes 85 übertragen. Mit diesem Teil des Druckes werden der oben genannte entsprechende Kontaktdom 78 niedergedrückt und die Schaltkontakte kurzgeschlossen.

Ein zweiter Teil des durch den Benutzer ausgeübten Druckes auf die Druckaufnahmeseiten 88 der Tastenelemente 52 der rechtwinklig zur Druckrichtung 61, beispielsweise in Blickrichtung 53 zeigt, verkippt das jeweilig gedrückte Tastenelement 52 in der entsprechenden Tastenführoffnung 62. Dies kann dazu führen, dass die Tastenelemente 52 in der entsprechenden Tastenführöffnung 62 verkanten. Die Wahrscheinlichkeit eines derartigen Verkantens nimmt mit einer abnehmenden Höhe 90 der Druckaufnahmeelemente 85 zu. Von diesen Höhen 90 sind in Fig. 7 der Übersichtlichkeit halber nicht alle mit einem eigenen Bezugszeichen versehen. Die Druckaufnahmeelemente 85 und ihre Höhen 90 können jedoch wie bereits ausgeführt, gerade in Fernbedienungen für Multimediageräte nicht beliebig klein gewählt werden.

Hier greift die flexible Leiterplatte 86 an, die Druckkräfte des Benutzers winklig zur Druckrichtung 61 aufnimmt und so dafür sorgen, dass auf die einzelnen Druckaufnahmeelemente 85 beim Drücken der Tastenelemente 52 nur Druckkräfte in der Druckrichtung 61 übertragen werden. Auf diese Weise wird ein Verkippen der Druckaufnahmeelemente 85 wirksam vermieden, unabhängig davon, welche Höhe 90 sie aufweisen.

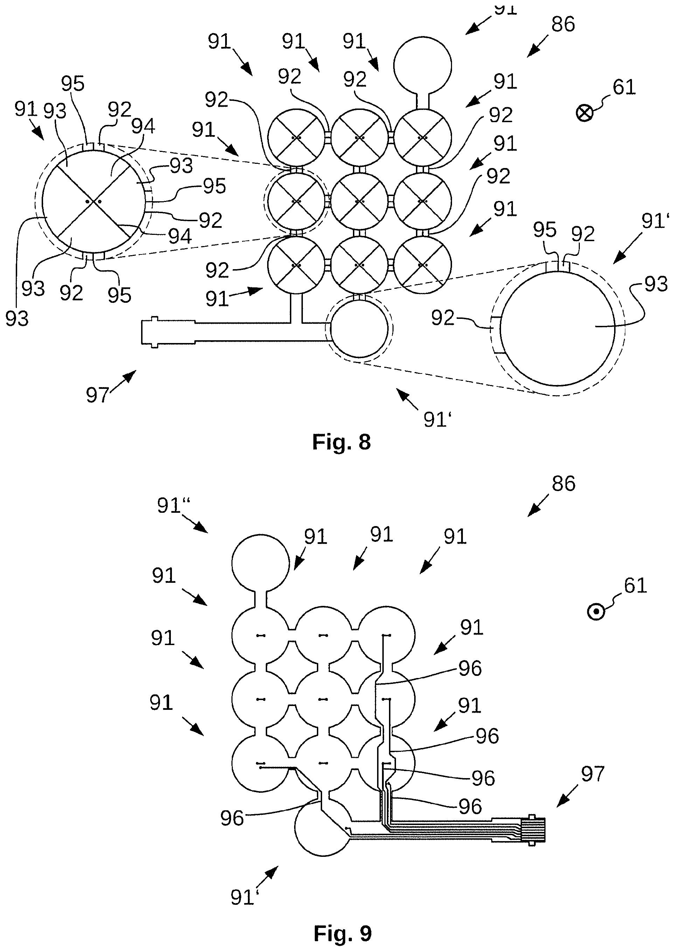

Die flexible Leiterplatte 31 soll nachstehend anhand der Fig. 8 und 9 näher beschrieben werden, die die flexible Leiterplatte 31 entsprechend in einer Draufsicht und in einer Ansicht von unten zeigen.

Die flexible Leiterplatte 86 umfasst in der vorliegenden Ausführung für jede Taste 52 des ersten Tastenfeldes 51 jeweils einen kopfförmigen Tastenbereich 91, 91', 91", die untereinander über Verbindungsstege 92 zu einem dem ersten Tastenfeld 51 entsprechenden Raster verbunden sind. Die kopfförmigen Tastenbereich 91, 91', 91" sind nachstehend der Übersichtlichkeit halber in drei verschiedene Arten unterteilt, worauf an späterer Stelle näher eingegangen wird. Auf den kopfförmigen Tastenbereichen 91, 91', 91" sind die Tasten 52 getragen, während die Verbindungsstege 92 für die zuvor beschriebene mechanische Stabilität zur Vermeidung des Verkantens sorgen. Von den Tastenbereichen 91 und den Verbindungsstegen 92 sind der Übersichtlichkeit halber nicht alle mit einem Bezugszeichen versehen.

Auf Tastenbereiche 91 der ersten Art und Tastenbereichen 91' der zweiten Art sind kapazitive Sensoren ausgebildet, um alternative eine Informationseingabe per Tastenberührung zu ermöglichen. Von diesen Tastenbereichen 91, 91' sind in Fig. 8 je einer beispielhaft vergrößert dargestellt.

Die Tastenbereiche 91 der ersten Art umfassen je mehrere segmentförmige Kondensatorplatten 93, die durch dielektrische Spalte 94 voneinander getrennt sind. Demgegenüber umfassen die Tastenbereiche 91' der zweiten Art nur eine einzige Kondensatorplatte 93. Die einzelnen Kondensatorplatten 93 sind über elektrische Leitungen 95 miteinander verbunden, die über die Verbindungsstege 92 geführt sind. Auf diese Weise ist ein Schaltnetzwerk aus flachen Kondensatoren geschaffen, dessen Kapzitätswerte von einem Benutzer durch Auflegen seines Fingers auf eine der Tasten 51 verändert werden kann.

Zur Auswertung dieser Kapazitätswerte des Kondensatornetzwerkes sind auf einer in Druckrichtung 61 gesehenen Rückseite der flexiblen Leiterplatte 86, die in Fig. 9 gezeigt ist, Auswerteleitungen 96 zu von einigen der Kondensatorplatten 93 durchkontaktiert durch die flexible Leiterplatte 86 zu einer elektrischen Schnittstelle 97 geführt. An diese elektrische Schnittstelle 97 kann eine an sich bekannte Kapazitätsauswerteeinrichtung angeschlossen und die Lage des Fingers des Benutzers auf einer der Tasten 52 des ersten Tastenfeldes 51 dediziert erfasst werden.

Daher ist auf der Fernbedienung 48 nicht nur eine Informationseingabe per Druck sondern auch eine Informationseingabe per Berührung zumindest über einen Teil der Tasten 52 auf der Fernbedienung 48 möglich. Auf diese Weise kann die Fernbedienung einem breiteren Benutzerpublikum angeboten werden, beispielsweise Benutzern, die eine Eingabe von Informationen mittels Hubtasten gewohnt sind und Benutzern, die eine Eingabe mittels Fingerberührungen gewohnt sind. Auch die Ausfallsicherheit ist durch die Fernbedienung 48 der vorliegenden Ausführung verbessert, weil redundant zwei Informationseingabesysteme vorgesehen sind. Dabei übernimmt das redundante Informationseingabesystem mittels kapazitiver Eingabetechnik gleichzeitig eine Stabilisierungsfunktion der einzelnen Hubtasten in der Fernbedienung 48.

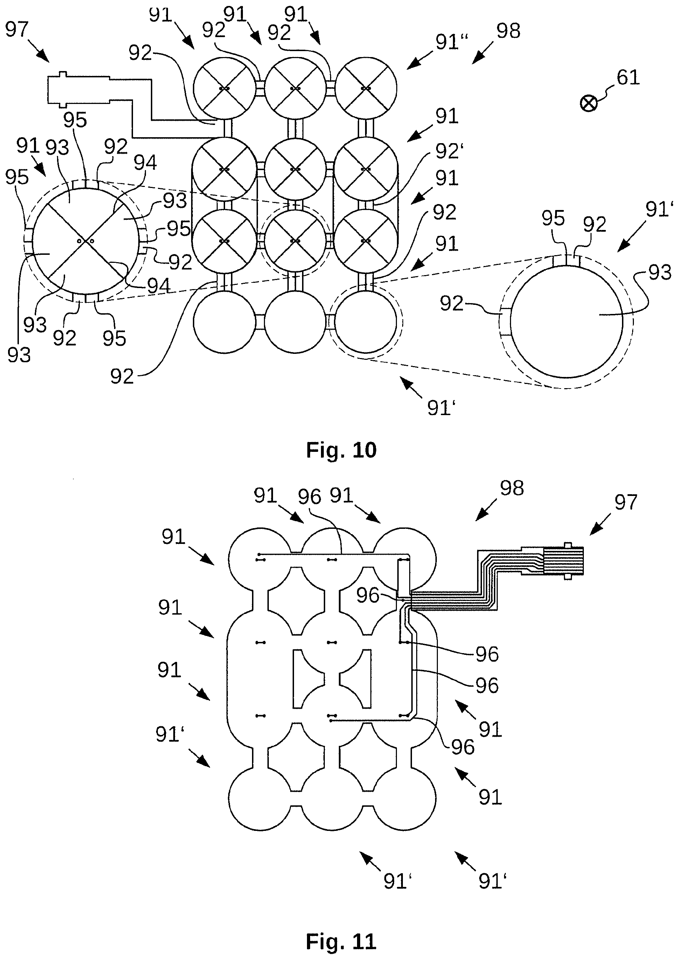

In den Fig. 10 und 11 ist eine flexible Leiterplatte 98 von der in Druckrichtung 61 gesehenen Oberseite beziehungsweise von der in Druckrichtung 61 gesehenen Unterseite abgebildet, die im zweiten Tastenfeld 60 in der Fernbedienung 48 verbaut ist. Die flexible Leiterplatte 98 des zweiten Tastenfeldes 60 ist analog zur flexiblen Leiterplatte 98 des ersten Tastenfeldes 51 aufgebaut. Einziger struktureller, nicht ausschließlich geometrischer Unterschied sind zwei verdickte Verbindungsstege 92', mit denen selbst Tastenwippen stabilisiert werden können.

## Patentansprüche

1. Fernbedienung (1, 48), umfassend
- erste Informationseinleseeinrichtung (24, 78) und eine zweite Informationseinleseeinrichtung (24, 78), die jeweils eingerichtet sind, eine Information basierend auf einem von einem Benutzer ausgeübten Druck in einer Druckrichtung (20, 61) einzulesen,
- ein der ersten Informationseinleseeinrichtung (24, 78) zugeordnetes erstes Druckaufnahmeelement (30) und ein der zweiten Informationseinleseeinrichtung (24, 78) zugeordnetes zweites Druckaufnahmeelement (30, 85), die jeweils eine Druckaufnahmeseite (35, 89) zum Aufnehmen des Druckes des Benutzers und eine Druckabgabeseite zum Abgeben des aufgenommenen Druckes an die jeweilige Informationseinleseeinrichtung (24, 78) besitzen,
- eine die Druckaufnahmeseiten (35, 89) der Druckaufnahmeelemente (30, 85) miteinander verbindende flexible Leiterplatte (31, 86, 97), auf der wenigstens ein kapazitiver Messaufnehmer (38, 39, 93, 94) ausgebildet ist, dessen Kapazität von der Lage eines Fingers des Benutzers auf der flexiblen Leiterplatte (31, 86, 97) abhängig ist, und
- ein erstes Tastenelement (14, 52) und ein zweites Tastenelement (15, 52), das jeweils auf einer der Druckaufnahmeseiten (35, 89) der Druckaufnahmeelemente (30, 85) gegenüberliegenden Seiten der flexiblen Leiterplatte (31, 86, 97) auf diese aufgelegt sind,
**dadurch gekennzeichnet, dass.**
- die flexible Leiterplatte (31) wenigstens an einem der Tastenelemente (14, 15) winklig zur Druckrichtung (20) gesehen formschlüssig (45) gehalten ist

2. Fernbedienung (1, 48) nach Anspruch 1, wobei die Tastenelemente (14, 15, 52) je eine Druckaufnahmeseite (34, 88) zur Aufnahme des Druckes vom Benutzer aufweisen, die in einem druckfreien Zustand in einer Ebene liegen.

3. Fernbedienung (1) nach Anspruch 1 oder 2, wobei die beiden Tastenelemente (14, 15) je eine Kante aufweisen, die aufeinander zugerichtet mit einem Spalt (37) von weniger als 1mm, vorzugsweise aneinander anliegend angeordnet sind.

4. Fernbedienung (1) nach Anspruch 3, wobei die Tastenelemente (14, 15) an der jeweiligen Kante in ihrer in der Druckrichtung (20) gesehenen Dicke (47) verjüngend ausgebildet sind.

5. Fernbedienung (1, 48) nach einem der Ansprüche 1 bis 4, wobei die flexible Leiterplatte (31, 86, 97) mit den Druckaufnahmeelementen (30, 85) und mit den Tastenelementen (14, 15, 52) klebend (28, 83) verbunden ist.

6. Fernbedienung (1) nach einem der Ansprüche 1 bis 5, wobei die flexible Leiterplatte (31) eine Beschichtung (46) in der Druckrichtung (20) unterhalb eines Übergangs (37) zwischen den beiden Tastenelementen (14, 15) aufweist.

7. Fernbedienung (1) nach einem der Ansprüche 1 bis 6, umfassend ein Steuerkreuz (7), wobei die beiden Tastenelemente (14, 15) umfänglich um das Steuerkreuz (7) angeordnet sind.

8. Fernbedienung (1) nach Anspruch 7, wobei das Steuerkreuz (7) auf der flexiblen Leiterplatte (31) aufliegt.

## Claims

1. Remote control (1, 48) comprising
- first information reading device (24, 78) and a second information reading device (24, 78), each of which is set up to read information based on a pressure exerted by a user in a printing direction (20, 61),
- a first pressure recording element (30) assigned to the first information reading device (24, 78) and a second pressure recording element (30, 85) assigned to the second information reading device (24, 78), each having a pressure recording side (35, 89) for receiving the pressure of the user and have a print delivery page for delivering the recorded pressure to the respective information reading device (24, 78),
- a, the pressure receiving sides (35, 89) of the pressure receiving elements (30, 85) interconnecting, flexible printed circuit board (31, 86, 97) on which at least one capacitive sensor (38, 39, 93, 94) is formed, which capacity is dependent on the location of a finger of the user on the flexible circuit board (31, 86, 97), and
- a first key element (14, 52) and a second key element (15, 52), that is respectively laid on the side of the flexible circuit board (31, 86, 97) opposite to the pressure receiving sides (35, 89) of the pressure receiving elements (30, 85)
**characterized in that**
- the flexible printed circuit board (31) is held at least on one of the key elements (14, 15) at an angle to the printing direction (20) in a positive manner (45).

2. Remote control (1, 48) according to claim 1, wherein the key elements (14, 15, 52) each have a pressure-receiving side (34, 88) for receiving the pressure from the user, which lie in a plane in a pressure-free state.

3. Remote control (1) according to claim 1 or 2, wherein the two key elements (14, 15) each have an edge, which are arranged facing each other with a gap (37) of less than 1mm, preferably abutting one another.

4. Remote control (1) according to claim 3, wherein the key elements (14, 15) are tapered at the respective edge in their thickness (47) seen in the printing direction (20).

5. Remote control (1, 48) according to any one of claims 1 to 4, wherein the flexible circuit board (31, 86, 97) with the pressure receiving elements (30, 85) and with the key elements (14, 15, 52) adhesive (28, 83) is connected.

6. Remote control (1) according to one of claims 1 to 5, wherein the flexible circuit board (31) has a coating (46) in the printing direction (20) below a transition (37) between the two key elements (14, 15).

7. Remote control (1) according to one of claims 1 to 6, comprising a control pad (7), the two key elements (14, 15) being arranged circumferentially around the control pad (7).

8. Remote control (1) according to claim 7, wherein the control cross (7) rests on the flexible circuit board (31).

## Revendications

1. Télécommande (1, 48), qui comporte
- un premier dispositif de lecture d'informations (24, 78) et un deuxième dispositif de lecture d'informations (24, 78), qui sont chacun conçus pour lire l'information dans une direction de pression (20, 61) sur la base d'une pression exercée par un utilisateur,
- un premier élément capteur de pression (30) associé au premier dispositif de lecture d'informations (24, 78) et un deuxième élément capteur de pression (30, 85) associé au deuxième dispositif de lecture d'informations (24, 78), qui ont chacun un côté de réception de pression (35, 89) pour recevoir la pression appliquée par l'utilisateur et un côté d'émission de pression pour émettre ladite pression vers le dispositif de lecture d'informations (24, 78) correspondant,
- une plaque de circuit imprimé flexible qui connecte l'un à l'autre les côtés de réception de pression (35, 89) des éléments capteurs de pression (30, 85) et sur laquelle est formé au moins un capteur de mesure capacitif (38, 39, 93, 94) dont la capacité dépend de la position d'un doigt de l'utilisateur sur la plaque de circuit imprimé flexible (31, 86, 97), et
- un premier élément de bouton (14, 52) et un deuxième élément de bouton (15, 52) qui sont chacun disposés sur l'un des côtés de la plaque de circuit imprimé flexible (31, 86, 97) à l'opposé des côtés de réception de pression (35, 89) des éléments capteur de pression (30, 85),
**caractérisée en ce que**
- la plaque de circuit imprimé flexible (31) est maintenue par une correspondance de formes (45) sur au moins l'un des éléments de bouton (14, 15) lorsqu'observée selon un angle par rapport à la direction de pression (20).

2. Télécommande (1, 48) selon la revendication 1, dans laquelle les éléments de bouton (14, 15, 52) ont chacun un côté de réception de pression (34, 88) pour recevoir la pression appliquée par l'utilisateur, lesquels côtés se situent dans un même plan dans un état d'absence de pression.

3. Télécommande (1) selon la revendication 1 ou la revendication 2, dans laquelle les deux éléments de bouton (14, 15) comportent chacun une arête, lesquelles arrêtes sont disposées en face l'une de l'autre avec un espace (37) de moins de 1 mm.

4. Télécommande (1) selon la revendication 3, dans laquelle les éléments de bouton (14, 15) sont biseautés selon leur arête respective le long de leur épaisseur (47) considérée dans la direction de pression (20).

5. Télécommande (1, 48) selon l'une quelconque des revendications 1 à 4, dans laquelle la plaque de circuit imprimé flexible (31, 86, 97) est fixée par collage (28, 83) aux éléments capteurs de pression (30, 85) et aux éléments de bouton (14, 15, 52).

6. Télécommande (1) selon l'une quelconque des revendications 1 à 5, dans laquelle la plaque de circuit imprimé flexible (31) comprend un enrobage (46) dans la direction de pression (20) au-dessous d'une transition (37) entre les deux éléments de bouton (14, 15).

7. Télécommande (1) selon l'une quelconque des revendications 1 à 6, comprenant un pavé directionnel (7), dans laquelle les deux éléments de bouton (14, 15) sont disposés autour de la circonférence du pavé directionnel (7).

8. Télécommande (1) selon la revendication 7, dans laquelle le pavé directionnel (7) est positionné sur la plaque de circuit imprimé flexible (31).
